# EUROPEAN PATENT SPECIFICATION

(11) **EP 3 316 348 B1**
(45) Date of publication and mention of the grant of the patent: **20.02.2019**
(21) Application number: 16195806.1
(22) Date of filing: 26.10.2016
(51) Int. Cl.: H01M 2/20, H01M 10/48

(54) **BUSBAR FOR A BATTERY SYSTEM AND BATTERY SYSTEM**
STROMSCHIENE FÜR EIN BATTERIESYSTEM UND BATTERIESYSTEM
BARRE OMNIBUS POUR SYSTÈME DE BATTERIE ET SYSTÈME DE BATTERIE

(43) Date of publication of application: 02.05.2018
(73) Proprietor: Samsung SDI Co., Ltd., Giheung-gu Yongin-si, Gyeonggi-do 17084 (KR)
(72) Inventor: Hofer, Maximilian, 8230 Hartberg (AT); Schmiedhofer, Christoph, 8020 Graz (AT)
(74) Representative: Gulde & Partner

(56) References cited:
- EP-A1- 2 541 641
- DE-A1-102007 033 182
- DE-A1-102013 210 128
- JP-A- 2012 160 552

## Description

### Field of the Invention

The present invention relates to a busbar for a battery system, particularly to a busbar with integrated shunt. The invention further relates to a battery system, particularly to a battery system comprising such busbar with integrated shunt.

### Technological Background

A rechargeable or secondary battery differs from a primary battery in that it can be repeatedly charged and discharged, while the latter provides only an irreversible conversion of chemical to electrical energy. Low-capacity rechargeable batteries are used as power supply for small electronic devices, such as cellular phones, notebook computers and camcorders, while high-capacity rechargeable batteries are used as the power supply for hybrid vehicles and the like.

In general, rechargeable batteries include an electrode assembly including a positive electrode, a negative electrode, and a separator interposed between the positive and negative electrodes, a case receiving the electrode assembly, and an electrode terminal electrically connected to the electrode assembly. An electrolyte solution is injected into the case in order to enable charging and discharging of the battery via an electrochemical reaction of the positive electrode, the negative electrode, and the electrolyte solution. The shape of the case, e.g. cylindrical or rectangular, depends on the battery's intended purpose.

Rechargeable batteries may be used as a battery module formed of a plurality of unit battery cells coupled in series and/or in parallel so as to provide a high energy density, e.g. for motor driving of a hybrid vehicle. That is, the battery module is formed by interconnecting the electrode terminals of the plurality of unit battery cells depending on a required amount of power and in order to realize a high-power rechargeable battery, e.g. for an electric vehicle.

Battery modules can be constructed either in block design or in modular design. In block designs, each battery cell is coupled to a common current collector structure and a common battery management system. In modular designs, pluralities of battery cells are connected to form submodules and several submodules are connected to form the battery module. Battery management functions may be realized either on module or submodule level and thus interchangeability of the components is improved. One or more battery modules are mechanically and electrically integrated, equipped with a thermal management system and set up for communication with one or more electrical consumers in order to form a battery system.

To provide thermal control of a battery system a thermal management system is required to safely use the at least one battery module by efficiently emitting, discharging and/or dissipating heat generated from its rechargeable batteries. If the heat emission/discharge/dissipation is not sufficiently performed, temperature deviations occur between respective battery cells, such that the at least one battery module cannot generate a desired amount of power. In addition, an increase of the internal temperature can lead to abnormal reactions occurring therein and thus charging and discharging performance of the rechargeable deteriorates and the life-span of the rechargeable battery is shortened. Thus, cell cooling for effectively emitting/discharging/dissipating heat from the cells is required.

To provide electrical integration of a battery system in modular designs either submodules with a plurality of cells connected in parallel are connected in series (XsYp) or submodules with a plurality of cells connected in series are connected in parallel (XpYs). XsYp type submodules are suitable for generating high voltages. As the voltage level of each cell has to be controlled individually, wiring complexity is increased though. In XpYs type submodules the voltage levels of all cells connected in parallel are automatically balanced. As it is hence sufficient to control the voltage on submodule level, the wiring complexity is reduced. In submodules of cells connected in parallel the capacitance of the cells add up and thus XpYs type submodules are mostly used with low capacitance cells.

For meeting the dynamic power demands of various electrical consumers connected to the battery system a static control of battery power output and charging is not sufficient. Thus, steady exchange of information between the battery system and the controllers of the electrical consumers is required. This information includes the battery systems actual state of charge (SoC), potential electrical performance, charging ability and internal resistance as well as actual or predicted power demands or surpluses of the consumers. Battery systems usually comprise a battery management system (BMS) and a battery management unit (BMU) for processing this information.

In general a Lithium ion battery system requires monitoring the voltage of each battery cell as over- and undervoltage might pose a security risk and might lower the service life of the system. Further the current of the battery system is detected in order to derive the actual SOC, e.g. by current-time-integration. A common method for measuring the battery current is to introduce a shunt with precisely known small ohmic resistance in the current path of the battery system. By measuring the voltage drop over the shunt, the current can be derived using the known resistance. As the voltage drop over the shunt is preferably small, a highly accurate voltage detection system, usually realized as an ASIC, has to be connected to the shunt.

Usually dedicated shunt sensors that are provided by specialized suppliers are used in in battery systems. These dedicated sensors have to be connected to customized circuit carriers that are especially manufactured for this purpose. Thus, the shunt sensor itself and the additional circuit carrier are producing extra costs. Particularly in automotive applications, a shunt sensor is often applied in a small housing that forms part of the positive battery clamp. Thus, the design of the clamps has to be adapted and additional installation space for the shunt has to be provided. Busbars for batteries with a two spaced-apart elements for connecting to cell terminals and a central third element connecting the two peripheral elements and having a defined ohmic resistance are known from prior art documents JP 2012 160552 A, DE 10 2007 033182 A1, DE 10 2013 210128 A1 and EP 2 541 641 A1.

It is thus an object of the present invention to overcome or reduce at least some of the drawbacks of the prior art and to provide a battery system with integrated shunt that can be cheaper with less costs and requires less installation space than the prior art solutions.

### Summary of Invention

One or more of the drawbacks of the prior art could be avoided or at least reduced by means of the present invention. In particular, a busbar for a battery system is provided that comprises a first bar element and a second bar element that are spaced apart, preferably along a length direction of the busbar and/or the battery system. The busbar is configured to connect cell terminals of battery cells and/or battery cell modules within the battery system. Preferably, the busbar is configured to electrically connect the terminals of battery cells with each other within the battery system. The busbar is further configured to be interchangeable with electric interconnectors, i.e. common busbars, used to interconnect the battery cells within the battery system. The bus bar further comprises a third bar element that connects the first bar element and the second bar element to form a common bar, i.e. to structurally connect the first bar element and second bar element. The third bar element can be detachable, e.g. by a plug or screwed connection, or non-detachable, e.g. welded, soldered or glued, attached to the first and second bar element.

According to the present invention, the third bar element is configured to electrically interconnect the first bar element and the second bar element as a shunt resistance with defined ohmic resistance. In other words, an ohmic resistor with well defined ohmic resistance is structurally and electrically integrated into the busbar. The shunt comprises a voltage drop of not more than 100 mV, preferably not more than 75 mV and particularly preferred not more than 50 mV at its maximum current, wherein the maximum current is a current of 250 A, preferably of 500 A and particularly preferred of 750 A. The shunt may also comprise an ohmic resistance between 10 µΩ and 200 µΩ, further preferred between 25 µΩ and 150 µΩ and particularly preferred between 50 µΩ and 100 µΩ. Further, the temperature coefficient of the shunt's resistance is preferably small, particularly preferred below 100 ppm, further preferred below 75 ppm and particularly preferred below 50 ppm. Further preferred, the shunt resistance, i.e. the third bar element, comprises or consists of Manganin, i.e. an alloy of 86 %copper, 12 % manganese and 2 % nickel. Alternatively, the third bar element comprises or consists of constantan, i.e. an alloy of 55 %copper and 45 % nickel.

Thus, according to the present invention an additional dedicated shunt as well as a circuit carrier for such additional shunt can be omitted. Thus, costs of material as well as installation space requirements are reduced compared to battery systems according to the prior art. The busbar according to the present invention is electrically connected to the cell terminals in a similar or the same way as the remaining electric interconnectors. Hence, further fixing means, e.g. additional screws, can be omitted and the overall robustness of the system is increased. The increase shunt resistance does not require additional contacts and thus the overall contact resistance in the battery system is reduced.

According to the present invention, each of the first bar element and the second bar element comprises a plurality of contact sections, wherein each contact section is configured to be electrically connected to a single cell terminal. In other words, the first bar element and the second bar element each comprise a segmented structure, wherein each segment is configured, e.g. in shape and size, to be electrically and/or structurally connected to a single cell terminal. Thus, the first and second bar elements are adapted to the amount of battery cells connected in parallel within the battery cell modules of the battery system. In other words, the busbar is configured to electrically connect battery cell modules in series, wherein each battery cell module comprises a plurality of single battery cells connected in parallel.

According to a first embodiment of the busbar, the first bar element, preferably a lower side of the first bar element, is configured to be electrically and/or structurally connected to at least one first cell terminal of a first polarity and the second bar element, preferably a lower side of the second bar element, is configured to be electrically and/or structurally connected to an equal amount of second cell terminals of a second polarity. The bar elements might be adapted in material, size and shape to the respective battery cell terminals to which they shall be connected. The first bar element and the second bar element can be configured to be connected to one or more of the respective cell terminals. Particularly, the respective bar elements are configured to be connected to a plurality of terminals of battery cells connected in parallel.

Particularly preferred, the first bar comprises the same material or consists of the same material as the first cell terminals of the first polarity. Thus, bimetallic corrosion is advantageously avoided. Therein, the material of the whole first bar element or only of a contact region configured to actually contact the first terminal is adapted to the first terminal's material. Further preferred, the second bar comprises the same material or consists of the same material as the second cell terminals of the second. Particularly preferred, the second bus bar comprises the same material or consists of the same material as the second cell terminals of the second polarity. Thus, bimetallic corrosion is advantageously avoided. Therein, the material of the whole second bar element or only of a contact region configured to actually contact the second terminal is adapted to the second terminal's material. In short, in the bus bar according to the present invention, the first bar element, the second bar element and the third bar element are made of different materials, wherein the first and second bar element are adapted to the material of a terminal with first or second polarity and the third bar element is made from a low resistance material, e.g. Manganin or Constantan. Further preferred the first, second and third bar element are welded to form a monolithic busbar with minimal contact resistance at interfaces between the bar elements.

The terminals of adjacent battery cells are not in immediate contact, e.g. due to space restrictions and to avoid shorts circuits or creeping. Thus, adjacent contact sections within the first bar element and adjacent contact sections within the second bar element are preferably electrically connected by separation sections. The size of these separation sections is adapted to the distance between adjacent battery terminals. In other words, the first and second bar elements comprise a segmented structure, wherein the sections within the bar elements are interconnected by the separation sections. The first bar element and the second bar element as whole are interconnected by the third bar element, i.e. the shunt resistance.

Particularly preferred, the width of the separation sections in a length direction of the busbar substantially equals the width of the third bar element in the length direction of the busbar and/or in the length direction of the battery system. The equal size of the third bar element and the separation sections allows for positioning the busbar according to the invention freely within the battery system. In other words, the busbar according to the invention and the electric interconnectors are interchangeable within the battery system. The electric interconnectors preferably comprise a first bar element and a second bar element that are identical to the bar elements of the busbar according to the invention. In contrast thereto, the first and second bar elements of the interconnector are electrically connected via a further separation section instead of a third bar element. However, the overall size of the busbar equals that of the interconnector, at least in the length direction of the battery system. As most of the components of busbar and interconnectors are identical a modular system is advantageously provided. In order to further enhance the interchangeability and modularity of the battery system, the first and second bar elements are preferably identically shaped.

In another preferred embodiment of the busbar according to the invention, a first contact pad is disposed on the first bar element, preferably on an upper side of the first bar element, immediately adjacent to the third bar section. Further preferred, a second contact pad is disposed on the second bar element, preferably on an upper side of the second bar element, immediately adjacent to the third bar section. Therein, the first contact pad and the second contact pad are configured to provide a high quality ohmic contact to a sensing circuit for the shunt resistance. Particularly preferred, the contact pads are configured to provide a high quality ohmic contact with low contact resistance with a contact structure, e.g. a wire bond, that connects each of the contact pads with the sensing circuit. Advantageously, by providing the contact pads next to the third bar element, the shunt can always measure the current of a single battery cell, independently of the amount of cell terminals connected in parallel and contacted by either the first or the second bar element. Also only a fraction of the bar element's surface has to be optimized for the high quality ohmic contact, e.g. by adapting the surface roughness or by coating the surface with a contact agent. Thus, costs of material can be further reduced and/or process steps can be omitted or optimized.

Another aspect of the present invention relates to a battery system, comprising a first system terminal of a first polarity and a second system terminal of a second polarity, wherein a plurality of battery cell modules is connected in series between the first system terminal and the second system terminal. Therein each battery cell module comprises at least one battery cell, wherein multiple battery cells are connected in parallel within a single battery cell module and wherein each battery cell comprises a first cell terminal of a first polarity and a second cell terminal of second polarity. The battery system further comprises at least one busbar according to the invention as described above. The busbar electrically interconnects the at least one second cell terminal of a first cell module and the at least one first cell terminal of a second cell module. Therein, the first bar element is electrically connected to the at least one second cell terminal of the first cell module and the second bar element is electrically connected to the at least one first cell terminal of the second cell module. Particularly preferred, the busbars are welded to the cell terminals for interconnecting the cell terminals.

According to the present invention, the distance between adjacent cell terminals in a length direction of the battery system substantially equals the width of the third bar element in the length direction of the battery system. In other words, the third bar element is adapted to the free spaces between adjacent cell terminals in the length direction of the battery system. Thus, the contact area of the sections of the bar elements with the respective cell terminals is optimized.

In other words, the busbar interconnects a first battery cell and/or a first battery cell module and a second battery cell and/or a second battery cell module within the battery system. In order to reduce installation space and wiring complexity, adjacent battery cells and/or battery cell modules connected in series are arranged in the battery system with alternated polarities, such that adjacent terminals of adjacent battery cells and/or battery cell modules have different polarity. In the battery system according to the invention, the busbar thus connects terminals of different polarities that usually comprise different materials. Preferably, the first bar element and the at least one second cell terminal comprise a first material, the second bar element and the at least one first cell terminals comprise a second material and the third bar element comprises a third material. Particularly preferred, the first, second and third material differ from each other.

According to a further preferred embodiment, the battery system comprises a plurality of electric interconnectors for interconnecting cell terminals which do not comprise a shunt. Each of the electric interconnectors comprises a first bar element and a second bar element that are spaced apart and that are each adapted, e.g. in shape, size and/or material, to be electrically connected to a cell terminal. The first bar element and the second bar element are preferably configured identical to the first and second bar element of the busbar as described above. Further preferred, the first bar element and the second bar element of the electric interconnector are electrically and structurally connected by a separation section. The width of the separation section substantially equals the distance between adjacent cell terminals in the length direction of the battery system. The battery system of this embodiment advantageously comprises a modular structure with respect to the busbar and the electric interconnectors and hence costs of material, installation space requirements and manufacturing complexity are decreased.

Particularly preferred, in the electric interconnectors as well as in the busbars the first bar element has the same shape and size as the second bar element. Thus, solely a single separation section has to be replaced by the third bar element to convert an electric interconnector into a busbar. Further, contact pads may be formed immediately adjacent to the third bar element.

Preferably, the battery system further comprises a cell supervision circuit (CSC) that is electrically connected to the busbar and comprises a sensing circuit, wherein the sensing circuit is configured to detect a voltage drop over the shunt resistance, e.g. a voltage between the first contact pad and the second contact pad. The cell supervision circuit comprises a first sensor pad that is electrically connected to the first contact pad and a second sensor pad that is electrically connected to the second contact pad. The CSC is further configured to monitor the cell voltages of some or each of the battery system's battery cells and may further be configured to actively or passively balance the voltages of the individual battery cells and/or to communicate with electric consumers or control electronics.

The CSC may comprise a circuit carrier such as a flexible circuit board (FCP) or a printed circuit board (PCB) and the sensing pads may be surface metallizations of the FCP or PCB. Further preferred, the busbar is wire bonded to the cell supervision circuit, e.g. each of the contact pads may be wire bonded to one of the sensor pads. The wires preferably comprises one or more of aluminum, copper, silver and gold. Particularly preferred, the CSC comprises further contact metallizations that are configured to be individually connected with single battery cells for voltage measurement, e.g. via wire bonding.

According to a preferred embodiment, the method for manufacturing a battery system according to the present invention may comprise the steps of: providing a plurality of battery cell modules, each module comprising at least one battery cell (connected in parallel) with a first cell terminal and a second cell terminal; assembling the battery cell modules by stacking the battery cell modules such that adjacent terminals of adjacent battery cell modules comprise different polarities; interconnecting the cell terminals of adjacent battery modules using electric interconnectors and at least one busbar according to the invention in order to electrically connect the plurality of battery modules in series between a first terminal and a second terminal; mechanically connecting the CSC with the assembled battery cell modules and wire bonding the contact metallizations of the CSC with the individual battery cells and the sensing pads with the contact pads of the busbar in a single wire bonding step.

Thus, the battery system according to the present can be manufactured in a simple method, wherein the electrical connection between the shunt resistance and the CSC is acquired simultaneously with the electrical connection between the CSC's contact metallizations and the individual battery cells for voltage measurements. Thus, an already existing process step can be utilized for electrically connecting the shunt resistance to a related sensing circuit which is provided on a CSC that was already part of the battery system. Thus, no additional mounting steps or components are required for adding the shunt resistance according to the invention to the battery system according to the invention.

Another aspect of the present invention relates to an electric vehicle, comprising a busbar as described above and/or comprising a battery system as described above. Further aspects of the present invention could be learned from the dependent claims or the following description.

### Brief Description of the Drawings

Features will become apparent to those of ordinary skill in the art by describing in detail exemplary embodiments with reference to the attached drawings in which:
Fig. 1 illustrates a schematic perspective view of a busbar according to an embodiment;
Fig. 2 illustrates a schematic top view of a battery system according to a first embodiment;
Fig. 3 illustrates a detailed top view of a battery system according to the first embodiment;
Fig. 4 illustrates a schematic perspective view of a battery system according to a second embodiment; and
Fig. 5 illustrates a detailed side view of a battery system according to the second embodiment.

### Detailed Description of the Invention

Reference will now be made in detail to embodiments, examples of which are illustrated in the accompanying drawings. Effects and features of the exemplary embodiments, and implementation methods thereof will be described with reference to the accompanying drawings. In the drawings, like reference numerals denote like elements, and redundant descriptions are omitted. The present invention, however, may be embodied in various different forms, and should not be construed as being limited to only the illustrated embodiments herein. Rather, these embodiments are provided as examples so that this disclosure will be thorough and complete, and will fully convey the aspects and features of the present invention to those skilled in the art.

Accordingly, processes, elements, and techniques that are not considered necessary to those having ordinary skill in the art for a complete understanding of the aspects and features of the present invention may not be described. In the drawings, the relative sizes of elements, layers, and regions may be exaggerated for clarity.

As used herein, the term "and/or" includes any and all combinations of one or more of the associated listed items. Further, the use of "may" when describing embodiments of the present invention refers to "one or more embodiments of the present invention." In the following description of embodiments of the present invention, the terms of a singular form may include plural forms unless the context clearly indicates otherwise.

It will be understood that although the terms "first" and "second" are used to describe various elements, these elements should not be limited by these terms. These terms are only used to distinguish one element from another element. For example, a first element may be named a second element and, similarly, a second element may be named a first element, without departing from the scope of the present invention. As used herein, the term "and/or" includes any and all combinations of one or more of the associated listed items. Expressions such as "at least one of," when preceding a list of elements, modify the entire list of elements and do not modify the individual elements of the list.

As used herein, the term "substantially," "about," and similar terms are used as terms of approximation and not as terms of degree, and are intended to account for the inherent deviations in measured or calculated values that would be recognized by those of ordinary skill in the art. Further, if the term "substantially" is used in combination with a feature that could be expressed using a numeric value, the term "substantially" denotes a range of +/- 5% of the value centered on the value.

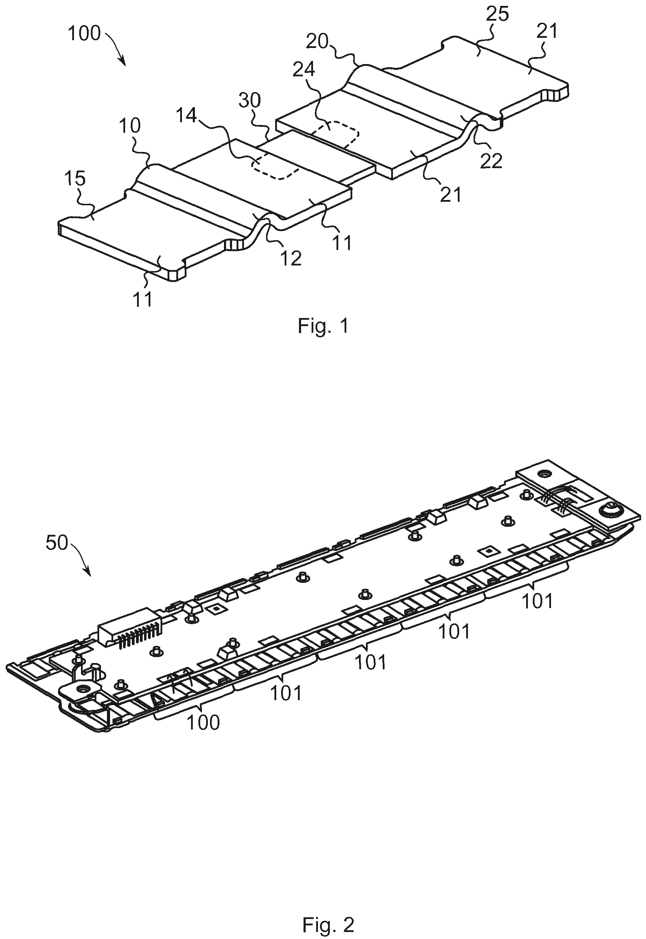

Figure 1 illustrates a busbar 100 according to an embodiment of the present invention. The busbar comprises a first bar element 10, a second bar element 20 and a third bar element 30. The first bar element 10 comprises two contact section 11 that are separated by a separation section 12, wherein the contact sections 11 are essentially plane and wherein the separation section 12 has an essentially curved shape. However, the separation section 12 may also be plane or formed as a recess between the contact sections 11. The first bar element 10 is adapted to be electrically connected with two second cell terminals of second polarity. Particularly, each of the contact sections 11 comprises a size and shape that is fitted to the size and shape of one second cell terminal. The first bar element 10 consists of aluminum which is also the material of the second cell terminals. The outermost contact section 11 further comprises a double-sided constriction, where it comprises an extension in the width direction of the busbar 100 that is less than the extension of the inner contact section 11 in the width direction. Within the constriction the busbar 100 is configured to engage with corresponding struts of a battery system for fixating the busbar 100 in a length direction of the busbar 100 which is perpendicular to the width direction of the busbar 100.

The second bar element 20 comprises two contact section 21 that are separated by a separation section 22, wherein the contact sections 21 are essentially plane and wherein the separation section 22 has an essentially curved shape. However, the separation section 22 may also be plane or formed as a recess between the contact sections 21. The second bar element 20 is adapted to be electrically connected with two first cell terminals of first polarity. Particularly, each of the contact sections 21 comprises a size and shape that is fitted to the size and shape of one first cell terminal. The second bar element 20 consists of copper which is also the material of the first cell terminals. The outermost contact section 21 further comprises a double-sided constriction, where it comprises an extension in the width direction of the busbar 100 that is less than the extension of the inner contact section 21 in the width direction. Within the constriction the busbar 100 is configured to engage with corresponding struts of a battery system for fixating the busbar 100 in a length direction of the busbar 100 which is perpendicular to the width direction of the busbar 100. In principal, the second bar element 20 has the identical size and shape of the first bar element 10.

The third bar element 30 is welded between the first bar element 10 and the second bar element 20 and thus structurally and electrically connects the first bar element 10 and the second bar element 20. The third bar element 30 comprises an extension in a width direction of the busbar 100 that is less then the extensions of the first and second bar element 10, 20 in the width direction of the busbar 100. The third bar element 100 consists of Manganin and thus comprises a well defined and low ohmic resistance that is almost not temperature-sensitive. The inner contact section 11 of the first bar element 10 comprises a first contact pad 14 and the inner contact section of the second bar element 20 comprises a second contact pad 24. The first and second contact pad 14, 24 are positioned immediately adjacent to the third bar element 30. In operation, the first bar element 10 is electrically connected to a cell terminal of second polarity and the second bar element 20 is electrically connected to a cell terminal of first polarity. Then, the current between these cell terminals can be derived from the voltage drop over third bar element 30 that is measured by connection the first and second contact pad 14, 24 to an appropriate sensing circuit.

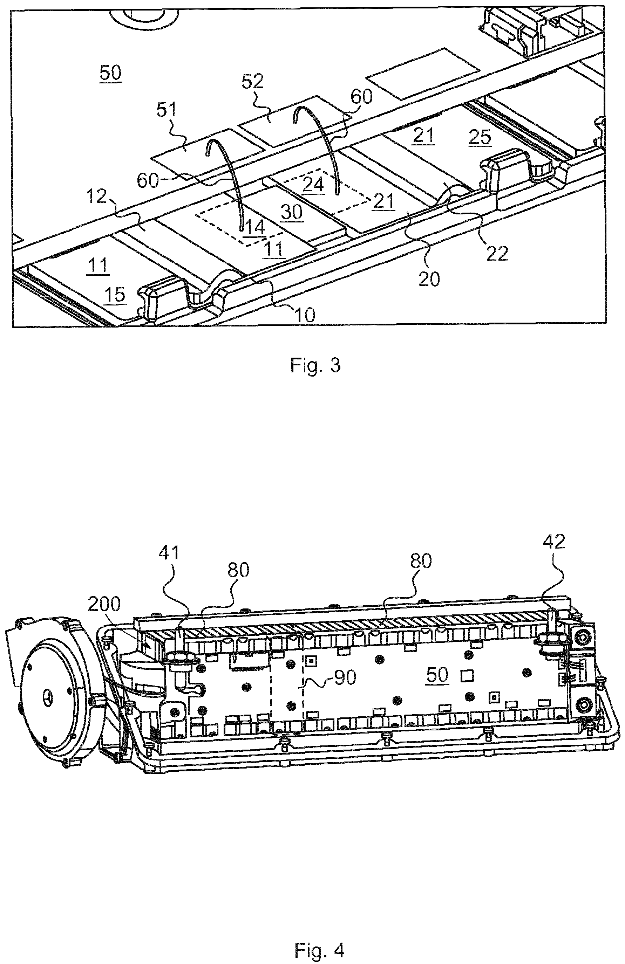

Figures 2 and 3 illustrate a battery system according to a first embodiment, wherein a circuit sensing circuit (CSC) 50 is mounted on top of the battery system. The CSC 50 comprises a circuit board (PCB) with a plurality of surface mounted electric components and metallizations for interconnecting these electric components. The top of the battery system further comprises a busbar 100 according to the invention and a plurality of electric interconnectors 101, each of which is structurally and electrically connected to four battery cell terminals of the battery cells stacked within the battery system. Thus, in the battery system each battery cell module comprises two battery cells connected in parallel and each electric interconnector 101 and the busbar 100 electrically connects two battery cell modules in series. The CSC 50 further comprises a first sensing pad 51 that is electrically connected to the first contact pad 14 via an aluminum wire 60 and a second sensing pad 52 that is electrically connected to the second contact pad 24 via another aluminum wire 60. In order to reduce the contact resistance between the wires 60 and the contact sections 11, 21 the aluminum contact pads 14, 24 are coated on to the upper surfaces 15, 25 of the first and second bar element 10, 20. Figure 3 illustrates how constrictions on two sides of both of the contact sections 11, 21 interact with a corresponding plug on one side of the busbar 100.

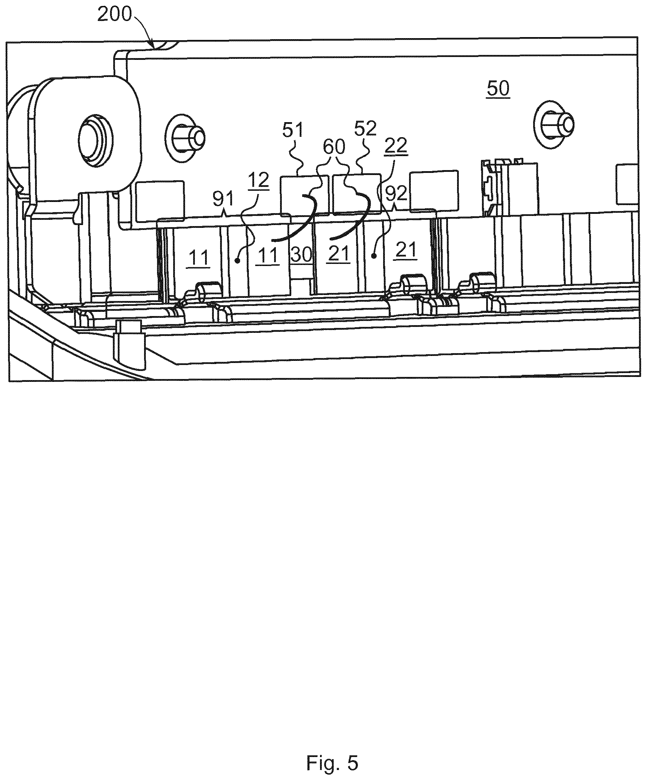

Figures 4 and 5 illustrate a battery system according to a second embodiment 200 according to a second embodiment. Therein a plurality of prismatic battery cells 80 are stacked in a length direction of the battery system 200, such that wide side surfaces of adjacent battery cells 80 face each other. Two battery cells 80 are electrically connected in parallel to form a battery cell module 90. In the battery system 200, subsequent battery cell modules 90 are arranged with alternating polarities, i.e. if a first battery cell modules 91 comprises two terminals of a first polarity on an upper side of the illustrated battery system 200 and two terminals of a second polarity on a lower side of the illustrated battery system 200 and an adjacent second battery cell module 92 comprises two terminals of a second polarity on an upper side of the illustrated battery system 200 and two terminals of a first polarity on a lower side of the illustrated battery system 200. Thus, e.g. the two terminals of a second polarity on the lower side of the illustrated battery system 200 of the first battery cell module 90 and the two terminals of a first polarity on the lower side of the illustrated battery system 200 can be electrically interconnected via busbar 100 or electric interconnector 101 in order to electrically connect the battery cell modules 90 in series. The plurality of battery cell module 90 stacked in the battery system 200 are electrically connected in series between the first system terminal 41 and the second system terminal 42 of the battery system 200. The battery system 200 further comprises a CSC 50 that is mechanically connected to the side of the battery system 200. The CSC 50 comprises a first sensing pad 51 that is electrically connected to the inner contact section 11 of the first bar element 10 via an aluminum wire 60 and a second sensing pad 52 that is electrically connected to the inner contact section 21 of the second bar element 20 via another aluminum wire 60.

The electronic or electric devices and/or any other relevant devices or components according to embodiments of the present invention described herein may be implemented utilizing any suitable hardware, firmware (e.g. an application-specific integrated circuit), software, or a combination of software, firmware, and hardware. For example, the various components of these devices may be formed on one integrated circuit (IC) chip or on separate IC chips. Further, the various components of these devices may be implemented on a flexible printed circuit film, a tape carrier package (TCP), a printed circuit board (PCB), or formed on one substrate. The electrical connections or interconnections described herein may be realized by wires or conducting elements, e.g. on a PCB or another kind of circuit carrier. The conducting elements may comprise metallization, e.g. surface metallizations and/or pins, and/or may comprise conductive polymers or ceramics. Further electrical energy might be transmitted via wireless connections, e.g. using electromagnetic radiation and/or light.

Further, the various components of these devices may be a process or thread, running on one or more processors, in one or more computing devices, executing computer program instructions and interacting with other system components for performing the various functionalities described herein. The computer program instructions are stored in a memory which may be implemented in a computing device using a standard memory device, such as, for example, a random access memory (RAM). The computer program instructions may also be stored in other non-transitory computer readable media such as, for example, a CD-ROM, flash drive, or the like.

Also, a person of skill in the art should recognize that the functionality of various computing devices may be combined or integrated into a single computing device, or the functionality of a particular computing device may be distributed across one or more other computing devices without departing from the scope of the exemplary embodiments of the present invention.

## Claims

1. A busbar (100) for a battery system (200), comprising:
a first bar element (10) and a second bar element (20) spaced apart;
a third bar element (30) connecting the first bar element (10) and the second bar element (20) to form a common bar;
wherein the third bar element (30) is configured to electrically interconnect the first bar element (10) and the second bar element (20) as a shunt resistance with defined ohmic resistance, and
wherein each of the first bar element (10) and the second bar element (20) comprises a plurality of contact sections (11,21) and wherein each contact section (11,21) is configured to be electrically connected to a single cell terminal.

2. The busbar (100) according to claim 1, wherein the first bar element (10) is configured to be electrically connected to at least two first cell terminals of a first polarity and wherein the second bar element (20) is configured to be electrically connected to an equal amount of second cell terminals of a second polarity.

3. The busbar (100) according to claim 1, wherein adjacent contact sections (11) within the first bar element (10) and adjacent contact sections (21) within the second bar element (20) are electrically connected by separation sections (12,22).

4. The busbar (100) according to claim 3, wherein the width of the separation sections (12,22) in a length direction of the busbar (100) substantially equals the width of the third bar element (30) in the length direction of the busbar (100).

5. The busbar (100) according to any one of the preceding claims, wherein the first bar element (10) consists of a first material adapted to a cell terminal of first polarity, the second bar element (20) consists of a second material adapted to a cell terminal of second polarity and the third bar element consist of Manganin or Constantan.

6. The busbar (100) according to any one of the preceding claims, wherein a first contact pad (14) is disposed on the first bar element (10) immediately adjacent to the third bar section (30) and wherein a second contact pad (24) is disposed on the second bar element (20) immediately adjacent to the third bar section (30).

7. A battery system (200), comprising:
a first system terminal (41) of a first polarity and a second system terminal (42) of a second polarity;
a plurality of battery cell modules (90) connected in series between the first system terminal (41) and the second system terminal (42), each battery cell module (90) comprising at least two battery cells (80), each with a first cell terminal of a first polarity and a second cell terminal of second polarity;
at least one busbar (100) according to any one of the claims 1 to 6, electrically interconnecting the at least two second cell terminals of a first cell module (91) and the at least two first cell terminals of a second cell module (92),
wherein the first bar element (10) is electrically connected to the at least two second cell terminals of the first cell module (91) and the second bar element (20) is electrically connected to the at least two first cell terminals of the second cell module (92), and
wherein the distance between a second cell terminal of the first cell module (91) and an adjacent first cell terminal of the second cell module (92) in a length direction of the battery system (200) substantially equals the width of the third bar element (30) in the length direction of the battery system (200).

8. The battery system (200) of claim 7, wherein the first bar element (10) and the at least two second cell terminals comprise a first material and wherein the second bar element (20) and the at least two first cell terminals comprise a second material.

9. The battery system (200) of claim 7 or 8, further comprising a plurality of electric interconnectors (101), comprising a first bar element (10) and a second bar element (20) spaced apart, wherein the first bar element (10) and the second bar element (20) are electrically and structurally connected by a separation section (12,22).

10. The battery system (200) according to any one of the claims 7 to 9, further comprising a cell supervision circuit (50) electrically connected to the busbar (100) and comprising a sensing circuit configured for measuring a voltage drop over the shunt resistance (30).

11. The battery system (200) according to claim 10, comprising a busbar (100) according to claim 6, wherein the cell supervision circuit (50) comprises a first sensor pad (51) electrically connected to the first contact pad (14) and a second sensor pad (52) electrically connected to the second contact pad (24).

12. The battery system (200) according to claim 10 or 11, wherein the busbar is wire bonded to the cell supervision circuit (50).

13. An electric vehicle, comprising a busbar (100) according to one of the claims 1 to 6 and/or a battery system (200) according to any one of the claims 7 to 12.

## Patentansprüche

1. Stromschiene (100) für ein Batteriesystem (200), die umfasst:
ein erstes Schienenelement (10) und ein zweites Schienenelement (20), die beabstandet angeordnet sind;
ein drittes Schienenelement (30), das das erste Schienenelement (10) und das zweite Schienenelement (20) miteinander verbindet, um eine gemeinsame Schiene zu bilden;
wobei das dritte Schienenelement (30) konfiguriert ist, um das erste Schienenelement (10) und das zweite Schienenelement (20) als einen Nebenschlusswiderstand mit einem definierten ohmschen Widerstand miteinander zu verbinden, und
wobei sowohl das erste Schienenelement (10) als auch das zweite Schienenelement (20) jeweils mehrere Kontaktabschnitte (11, 21) umfasst, und wobei jeder Kontaktabschnitt (11, 21) konfiguriert ist, mit einem einzelnen Zellenanschluss elektrisch verbunden zu werden.

2. Stromschiene (100) nach Anspruch 1, wobei das erste Schienenelement (10) konfiguriert ist, mit mindestens zwei ersten Zellenanschlüssen einer ersten Polarität elektrisch verbunden zu werden, und wobei das zweite Schienenelement (20) konfiguriert ist, mit einer gleichen Menge an zweiten Zellenanschlüssen einer zweiten Polarität elektrisch verbunden zu werden.

3. Stromschiene (100) nach Anspruch 1, wobei benachbarte Kontaktabschnitte (11) innerhalb des ersten Schienenelements (10) und benachbarte Kontaktabschnitte (21) innerhalb des zweiten Schienenelements (20) durch Trennabschnitte (12,22) elektrisch verbunden sind.

4. Stromschiene (100) nach Anspruch 3, wobei die Breite der Trennabschnitte (12,22) in einer Längsrichtung der Stromschiene (100) im Wesentlichen der Breite des dritten Schienenelements (30) in der Längsrichtung der Stromschiene (100) gleicht.

5. Stromschiene (100) nach einem der vorhergehenden Ansprüche, wobei das erste Schienenelement (10) aus einem ersten Material besteht, das für einen Zellenanschluss einer ersten Polarität ausgelegt ist, wobei das zweite Schienenelement (20) aus einem zweiten Material besteht, das für einen Zellenanschluss einer zweiten Polarität ausgelegt ist, und wobei das dritte Schienenelement (30) aus Manganin oder Konstantan besteht.

6. Stromschiene (100) nach einem der vorhergehenden Ansprüche, wobei ein erster Kontaktbereich (14) auf dem ersten Schienenelement (10) unmittelbar benachbart zu dem dritten Schienenelement (30) angeordnet ist, und wobei ein zweiter Kontaktbereich (24) auf dem zweiten Schienenelement (20) unmittelbar benachbart zu dem dritten Schienenelement (30) angeordnet ist.

7. Batteriesystem (200), das umfasst:
einen ersten Systemanschluss (41) einer ersten Polarität und einen zweiten Systemanschluss (42) einer zweiten Polarität;
mehrere Batteriezellenmodule (90), die in Serie zwischen dem ersten Systemanschluss (41) und dem zweiten Systemanschluss (42) verbunden sind, wobei jedes Batteriezellenmodul (90) mindestens zwei Batteriezellen (80) umfasst, von denen jede einen ersten Zellenanschluss einer ersten Polarität und einen zweiten Zellenanschluss einer zweiten Polarität aufweist;
mindestens eine Stromschiene (100) nach einem der Ansprüche 1 bis 6, die die mindestens zwei zweiten Zellenanschlüsse eines ersten Zellenmoduls (91) und die mindestens zwei ersten Zellenanschlüsse eines zweiten Zellenmoduls (92) miteinander verbinden,
wobei das erste Schienenelement (10) mit den mindestens zwei zweiten Zellenanschlüssen des ersten Zellenmoduls (91) elektrisch verbunden ist, und wobei das zweite Schienenelement (20) mit den mindestens zwei ersten Zellenanschlüssen des zweiten Zellenmoduls (92) verbunden ist, und
wobei der Abstand zwischen einem zweiten Zellenanschluss des ersten Zellenmoduls (91) und einem benachbarten ersten Zellenanschluss des zweiten Zellenmoduls (92) in einer Längsrichtung des Batteriesystems (200) im Wesentlichen der Breite des dritten Schienenelements (30) in der Längsrichtung des Batteriesystems (200) gleicht.

8. Batteriesystem (200) nach Anspruch 7, wobei das erste Schienenelement (10) und die mindestens zwei zweiten Zellenanschlüsse ein erstes Material umfassen, und wobei das zweite Schienenelement (20) und die mindestens zwei ersten Zellenanschlüsse ein zweites Material umfassen.

9. Batteriesystem (200) nach Anspruch 7 oder 8, das ferner mehrere elektrische Zwischenschalter (101) umfasst, die ein erstes Schienenelement (10) und ein zweites Schienenelement (20), die beabstandet angeordnet sind, umfassen, wobei das erste Schienenelement (10) und das zweite Schienenelement (20) elektrisch und strukturell durch einen Trennabschnitt (12,22) verbunden sind.

10. Batteriesystem (200) nach einem der Ansprüche 7 bis 9, das ferner einen Zellenüberwachungsschaltkreis (50) umfasst, der elektrisch mit der Stromschiene (100) verbunden ist, und das einen Messschaltkreis umfasst, der konfiguriert ist, um einen Spannungsabfall über den Nebenschlusswiderstand (30) zu messen.

11. Batteriesystem (200) nach Anspruch 10, das eine Stromschiene (100) nach Anspruch 6 umfasst, wobei der Zellenüberwachungsschaltkreis (50) einen ersten Sensorbereich (51), der elektrisch mit dem ersten Kontaktbereich (14) verbunden ist, und einen zweiten Sensorbereich (52), der elektrisch mit dem zweiten Kontaktbereich (24) verbunden ist, umfasst.

12. Batteriesystem (200) nach Anspruch 10 oder 11, wobei die Stromschiene mit dem Zellenüberwachungsschaltkreis (50) draht-verbunden ist.

13. Elektrisches Fahrzeug, das eine Stromschiene (100) nach einem der Ansprüche 1 bis 6 und/oder ein Batteriesystem (200) nach einem der Ansprüche 7 bis 12 umfasst.

## Revendications

1. Barre omnibus (100) pour un système de batterie (200), comprenant :
un premier élément de barre (10) et un deuxième élément de barre (20) espacés ;
un troisième élément de barre (30) reliant le premier élément de barre (10) et le deuxième élément de barre (20) pour former une barre commune ;
dans laquelle le troisième élément de barre (30) est configuré pour relier électriquement le premier élément de barre (10) et le deuxième élément de barre (20) en tant que résistance en dérivation ayant une résistance ohmique définie, et
dans laquelle chacun du premier élément de barre (10) et du deuxième élément de barre (20) comprend une pluralité de sections de contact (11, 21) et où chaque section de contact (11, 21) est configurée pour être reliée électriquement à une borne de cellule unique.

2. Barre omnibus (100) selon la revendication 1, dans laquelle le premier élément de barre (10) est configuré pour être relié électriquement à au moins deux premières bornes de cellules d'une première polarité et où le deuxième élément de barre (20) est configuré pour être relié électriquement à une quantité égale de deuxièmes bornes de cellules d'une deuxième polarité.

3. Barre omnibus (100) selon la revendication 1, dans laquelle des sections de contact adjacentes (11) dans le premier élément de barre (10) et des sections de contact adjacentes (21) dans le deuxième élément de barre (20) sont reliées électriquement par des sections de séparation (12, 22) .

4. Barre omnibus (100) selon la revendication 3, dans laquelle la largeur des sections de séparation (12, 22) dans la direction de la longueur de la barre omnibus (100) est sensiblement égale à la largeur du troisième élément de barre (30) dans la direction de la longueur de la barre omnibus (100).

5. Barre omnibus (100) selon l'une quelconque des revendications précédentes, dans laquelle le premier élément de barre (10) est constitué d'un premier matériau adapté à une borne de cellule de première polarité, le deuxième élément de barre (20) est constitué d'un deuxième matériau adapté à une borne de cellule de deuxième polarité et le troisième élément de barre est constitué de Manganine ou de Constantan.

6. Barre omnibus (100) selon l'une quelconque des revendications précédentes, dans laquelle une première plage de contact (14) est disposée sur le premier élément de barre (10) à proximité immédiate de la troisième section de barre (30) et où une deuxième plage de contact (24) est disposée sur le deuxième élément de barre (20) à proximité immédiate de la troisième section de barre (30).

7. Système de batterie (200) comprenant :
une première borne de système (41) d'une première polarité et une deuxième borne de système (42) d'une deuxième polarité ;
une pluralité de modules de cellules de batterie (90) reliés en série entre la première borne de système (41) et la deuxième borne de système (42), chaque module de cellules de batterie (90) comprenant au moins deux cellules de batterie (80), chacune ayant une première borne de cellule d'une première polarité et une deuxième borne de cellule d'une deuxième polarité ;
au moins une barre omnibus (100) selon l'une quelconque des revendications 1 à 6, reliant électriquement les au moins deux deuxièmes bornes de cellules d'un premier module de cellule (91) et les au moins deux premières bornes de cellules d'un deuxième module de cellules (92),
dans lequel le premier élément de barre (10) est relié électriquement aux au moins deux deuxièmes bornes de cellules du premier module de cellules (91) et le deuxième élément de barre (20) est relié électriquement aux au moins deux premières bornes de cellules du deuxième module de cellules (92), et
dans lequel la distance entre une deuxième borne de cellule du premier module de cellules (91) et une première borne de cellule adjacente du deuxième module de cellules (92) dans la direction de la longueur du système de batterie (200) est sensiblement égale à la largeur du troisième élément de barre (30) dans la direction de la longueur du système de batterie (200).

8. Système de batterie (200) de la revendication 7, dans lequel le premier élément de barre (10) et les au moins deux deuxièmes bornes de cellules comprennent un premier matériau et où le deuxième élément de barre (20) et les au moins deux premières bornes de cellules comprennent un deuxième matériau.

9. Système de batterie (200) de la revendication 7 ou 8, comprenant en outre une pluralité d'interconnecteurs électriques (101), comprenant un premier élément de barre (10) et un deuxième élément de barre (20) espacés, où le premier élément de barre (10) et le deuxième élément de barre (20) sont reliés électriquement et structurellement par une section de séparation (12, 22).

10. Système de batterie (200) selon l'une quelconque des revendications 7 à 9, comprenant en outre un circuit de surveillance de cellules (50) relié électriquement à la barre omnibus (100) et comprenant un circuit de détection configuré pour mesurer une chute de tension sur la résistance en dérivation (30).

11. Système de batterie (200) selon la revendication 10, comprenant une barre omnibus (100) selon la revendication 6, dans lequel le circuit de surveillance de cellules (50) comprend une première plage de détection (51) reliée électriquement à la première plage de contact (14) et une deuxième plage de détection (52) reliée électriquement à la deuxième plage de contact (24).

12. Système de batterie (200) selon la revendication 10 ou 11, dans lequel la barre omnibus est un fil lié au circuit de surveillance de cellules (50).

13. Véhicule électrique, comprenant une barre omnibus (100) selon l'une des revendications 1 à 6 et/ou un système de batterie (200) selon l'une quelconque des revendications 7 à 12.
